# EUROPÄISCHE PATENTSCHRIFT

(11) **EP 3 857 243 B1**
(45) Veröffentlichungstag und Bekanntmachung des Hinweises auf die Patenterteilung: **15.05.2024**
(21) Anmeldenummer: 19786483.8
(22) Anmeldetag: 27.09.2019
(51) Int. Cl.: G01R 31/327, G01R 31/333, H02H 3/04

(54) **VERFAHREN ZUM TESTEN EINES BIMETALLSCHALTERS**
METHOD FOR TESTING A BIMETALLIC SWITCH
PROCÉDÉ DE TEST D'UN COMMUTATEUR À BILAME

(30) Priorität: 27.09.2018 PT 2018115043
(43) Veröffentlichungstag der Anmeldung: 04.08.2021
(73) Patentinhaber: Bosch Termotecnologia S.A., 3800-533 Aveiro (PT)
(72) Erfinder: MATOS DE OLIVEIRA, Elder, 3865-026 Estarreja (PT); MOURA, Tiago, 3800-740 Aveiro (PT); PEREIRA, Paulo, 3730-105 Vale de Cambra (PT)
(74) Vertreter: Bee, Joachim
(86) Internationale Anmeldenummer: PCT/EP2019/076310
(87) Internationale Veröffentlichungsnummer: WO 2020/065067

(56) Entgegenhaltungen:
- CN-A- 105 548 868
- CN-B- 105 589 034
- CN-U- 201 615 903
- DE-B- 1 067 928
- DE-B- 1 176 253
- US-A- 2 541 121
- US-A1- 2006 208 846
- US-B1- 6 246 241
- US-B1- 6 472 882

## Beschreibung

Die vorliegende Erfindung betrifft ein Verfahren zum Testen eines Bimetallschalters einer Vorrichtung, insbesondere einer Heizvorrichtung. Die Erfindung betrifft auch eine Vorrichtung, insbesondere eine Heizvorrichtung, mit einem Bimetallschalter, sowie eine Vorrichtung zum Testen des Bimetallschalters.

### Stand der Technik

Es sind Heizvorrichtungen mit Bimetallschaltern bekannt, bei welchen die Bimetallschalter getestet werden, indem mittels eines Gebläses die Bimetallschalter mit heißer Luft erhitzt werden. Dabei werden auch umliegende Komponenten der Heizvorrichtung unnötig erhitzt.

Die Dokumente US6,246,241B1, US6,472,882B1 und CN105589034B beschreiben ebenfalls ein Verfahren sowie eine Vorrichtung zum Testen eines Bimetallschalters.

### Offenbarung der Erfindung

Die Erfindung betrifft ein Verfahren gemäß Anspruch 1 sowie eine Vorrichtung gemäß Anspruch 5. Vorteilhafte Ausführungen der Erfindung werden in den abhängigen Ansprüchen beschrieben.

Das vorliegende Verfahren mit den Merkmalen des Hauptanspruchs hat demgegenüber den Vorteil, dass in und/oder an die Vorrichtung, insbesondere die Heizvorrichtung, eine Induktionsspule (26) gebracht wird, mittels welcher ein Bimetall (14) des Bimetallschalters (12) induktiv erhitzt wird. Dadurch kann ein Testen des Bimetallschalters gezielt und schnell während eines Herstellungsprozesses der Vorrichtung, insbesondere der Heizvorrichtung, erfolgen, wobei ein Erhitzen umliegender Komponenten vermieden wird.

Gemäß der Erfindung wird durch das induktive Erhitzen des Bimetalls des Bimetallschalters eine Biegung des Bimetalls ausgeführt, durch welche ein Schalter betätigt wird, wodurch eine effiziente Funktionserkennung ermöglicht wird.

Vorteilhaft ist es, wenn das Betätigen des Schalters durch die Vorrichtung, vorzugsweise durch eine Steuereinheit der Vorrichtung, erfasst wird. Wodurch eine separate Steuereinheit zum Testen des Bimetallschalters nicht benötigt wird.

Besonders vorteilhaft ist es, wenn durch das Betätigen des Schalters ein elektrisches Signal unterbrochen wird, wodurch eine besonders effiziente und schnelle Funktionserkennung ermöglicht wird.

Besonders vorteilhaft ist es auch, wenn elektrische Signal mittels der Vorrichtung, vorzugsweise der Steuereinheit der Vorrichtung, überwacht wird, wodurch der Automatisierungsgrad erhöht wird.

Gemäß der Erfindung wird durch das Betätigen des Schalters, insbesondere durch das Unterbrechen des elektrischen Signals, ein Regelungsvorgang der Vorrichtung eingeleitet und/oder ein Signal generiert, welches Aufschluss über die Funktionsfähigkeit des Bimetallschalters gibt. Dadurch kann der Bimetallschalter in Verbindung mit der Vorrichtung vorteilhaft getestet werden.

Gemäß der Erfindung wird durch den Regelungsvorgang ein Element, insbesondere ein Gasventil, der Vorrichtung betätigt, vorzugsweise geschlossen. Dadurch kann der Bimetallschalter in Verbindung mit einzelnen Elementen der Vorrichtung vorteilhaft getestet werden.

Die Erfindung betrifft auch, eine Vorrichtung, insbesondere eine Heizvorrichtung, mit einem Bimetallschalter und eine Vorrichtung zum Testen des Bimetallschalters, welche dazu eingerichtet sind den Bimetallschalter mit einem Verfahren nach der vorhergehenden Beschreibung zu testen.

Vorteilhaft ist es, wenn die Vorrichtung zum Testen des Bimetallschalters eine Induktionsspule aufweist, welche dazu vorgesehen ist ein Bimetall des Bimetallschalters zu erhitzen, wodurch ein besonders effizientes, gezieltes und schnelles erhitzen des Bimetalls ermöglicht wird.

Auch ist es vorteilhaft, wenn die Vorrichtung, insbesondere die Heizvorrichtung, ein Positionierungselement für eine Induktionsspule zum Testen des Bimetallschalters aufweist, wodurch das Testen eines Bimetallschalters vereinfacht wird.

### Zeichnungen

In den Zeichnungen ist ein Ausführungsbeispiel der Erfindung schematisch dargestellt und in der nachfolgenden Beschreibung näher erläutert. Es zeigen
- Fig. 1: eine schematische Darstellung einer Heizvorrichtung mit einem Bimetallschalter,
- Fig. 2: eine weitere schematische Darstellung der Heizvorrichtung aus Fig. 1.

### Beschreibung der Ausführungsbeispiele

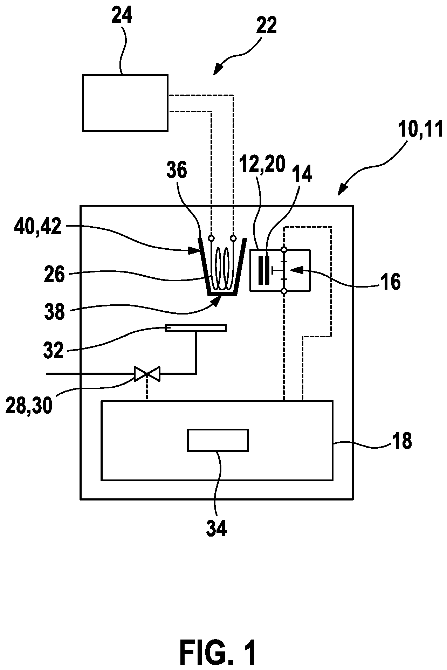

In der Fig. 1 ist eine schematische Darstellung einer Vorrichtung 10, im vorliegenden Fall einer Heizvorrichtung 11, mit einem Bimetallschalter 12 gezeigt. Die gezeigte Heizvorrichtung 11 kann im vorliegenden Fall dazu verwendet werden ein Fluid für den häuslichen Gebrauch zu erwärmen. So kann durch die Heizvorrichtung 11 beispielsweise Kaltwasser erwärmt werden, wodurch Warmwasser als Brauchwasser zur Verfügung gestellt werden kann. Auch wäre es denkbar das Heizwasser erwärmt wird, wodurch warmes Heizwasser für einen Heizkreislauf zur Verfügung gestellt werden kann. Ebenso wäre es denkbar, dass durch die Heizvorrichtung 11 Luft für eine Klimaanlage erwärmt wird.

Alternativ wäre es aber auch denkbar, dass es sich bei der Vorrichtung 10 um eine andere dem Fachmann geläufige Vorrichtung mit einem Bimetallschalter 12, wie beispielsweise eine Kaffeemaschine, eine Waschmaschine, eine Spülmaschine etc., handelt.

Der Bimetallschalter 12 weist ein Bimetall 14 und einen Schalter 16 auf. Der Bimetallschalter 12, bzw. der Schalter 16, ist mit einer Steuereinheit 18 der Heizvorrichtung 11 elektronisch verbunden.

Bei dem Bimetallschalter 12 handelt es sich im vorliegenden Fall um einen Temperaturschalter 20. Der Temperaturschalter 20 dient im Normalbetrieb der Heizvorrichtung 11 zur Abschaltung der Heizvorrichtung 11 bei einer Übertemperatur. Entsprechend kann der Bimetallschalter 12 auch als Temperatursicherung oder Thermosicherung verstanden werden.

Es kann vorkommen, dass solche Bimetallschalter 12 bei der Herstellung der Heizvorrichtung 11 fehlerhaft montiert oder sogar schon vor der Montage defekt sind. Entsprechend kann es vorkommen, dass solche Bimetallschalter 12 eine fehlerhafte Regelung der Heizvorrichtung 11 verursachen. Daher ist es wünschenswert solche Bimetallschalter zu testen. Üblicherweise werden solche Bimetallschalter 12 getestet, indem sie mittels eines Gebläses erhitzt werden. Dabei werden umliegende Komponenten unnötig erhitzt. Darüber hinaus ist das Testen mittels eines Gebläses verhältnismäßig langsam, da es relativ lange dauert bis ein solcher Bimetallschalter 12 mittels eines Gebläses erhitzt wird.

Durch das vorliegende Verfahren zum Testen eines Bimetallschalters 12 wird nun in und/oder an die Heizvorrichtung 11 eine Induktionsspule 26 gebracht, mittels welcher ein Bimetall 14 des Bimetallschalters 12 induktiv erhitzt wird. Dadurch kann ein gezieltes und schnelles erhitzen des Bimetalls 14 in dem Bimetallschalter 12 erfolgen. Dabei wird zum einen vermieden, dass umliegende Komponenten unnötig erhitzt werden und zum anderen wird die Zeit die zum Testen benötigt wird deutlich reduziert.

Darüber hinaus kann durch das vorliegende Verfahren sowohl die Funktionsfähigkeit des Bimetallschalters 12 selbst als auch die Funktionsfähigkeit des Bimetallschalters 12 in Verbindung mit der Heizvorrichtung 11 getestet werden. Entsprechend kann ein Test des Bimetallschalters 12 während der Herstellung der Heizvorrichtung 11 durchgeführt werden, wobei der Bimetallschalter 12 schon vorab in der Heizvorrichtung 11 montiert ist. Durch das vorliegende Verfahren kann ebenso ein Test des Bimetallschalters 12 während einer Wartung der Heizvorrichtung 11 durchgeführt werden.

In dem in Fig. 1 gezeigten Fall wird das Bimetall 14 des Bimetallschalters 12 mittels einer Vorrichtung 22 zum Testen des Bimetallschalters 12 induktiv erhitzt. Die Vorrichtung 22 zum Testen des Bimetallschalters 12 umfasst im gezeigten Fall eine Elektronikeinheit 24 und eine Induktionsspule 26. Dabei wird für einen Test des Bimetallschalters 12 die Induktionsspule 26 an den Bimetallschalter 12 in die Heizvorrichtung 11 eingebracht. Die Induktionsspule 26 ist elektronisch mit der Elektronikeinheit 24 verbunden. Entsprechend kann mittels der Elektronikeinheit 24 ein elektrischer Strom eingestellt werden, der durch die Induktionsspule 26 fließt und ein Magnetfeld um die Induktionsspule 26 herum erzeugt wird. Durch das erzeugte Magnetfeld wiederum wird in dem Bimetall 14 ein Induktionsstrom erzeugt, durch welchen gezielt das Bimetall 14 induktiv erhitzt wird. Der elektrische Strom der durch die Induktionsspule 26 fließt kann dabei nur so eingestellt werden, dass keine Schäden am Bimetallschalter 12 entstehen können. So kann der durch die Induktionsspule 26 fließende Strom einen Grenzwert nicht überschreiten, der einer maximal annehmbaren Temperatur des Bimetallschalters 12 entspricht.

Die Heizvorrichtung 11 weist im gezeigten Fall ein Positionierungselement 36 für die Induktionsspule 26 zum Testen des Bimetallschalters 12 auf. Dadurch kann die Induktionsspule 26 gezielt in einem Abstand zu dem Bimetallschalter 12 positioniert werden, der einen maximalen Induktionsstrom im Bimetall 14 induziert. Das Positionierungselement 36 ist korrespondierend zu der Induktionsspule 26 ausgebildet. Im vorliegenden Fall umfasst das Positionierungselement 36 einen Anschlag 38 und zwei Führungen 40. Dabei sind die Führungen 40 leicht schräg angeordnet, weshalb sie auch als Einführungshilfen 42 fungieren. Dadurch kann die Induktionsspule 26 zum Testen des Bimetallschalters 12 besonders einfach in die Heizvorrichtung 11 eingebracht werden.

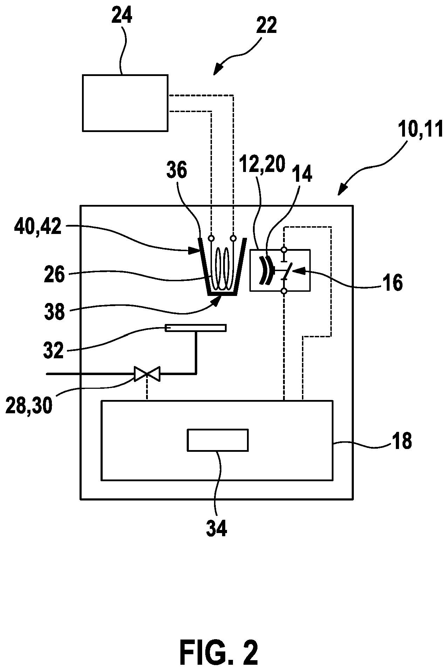

Durch das induktive Erhitzen des Bimetalls 14 des Bimetallschalters 12 wird eine Biegung des Bimetalls 14 ausgeführt, durch welche der Schalter 16 betätigt wird. Dadurch wird eine effiziente Funktionserkennung des Bimetallschalters 12 ermöglicht. Entsprechend ist in Fig. 2 eine weitere schematische Darstellung der Heizvorrichtung 11 gezeigt, bei welcher eine Biegung des Bimetalls 12 durchgeführt wurde und der Schalter 16 betätigt wurde. Die Biegung des Bimetalls 12 ist dabei temperaturabhängig. Je höher die Temperatur, desto stärker die Biegung des Bimetalls 12.

Das Betätigen des Schalters wird durch die Heizvorrichtung 11, bzw. durch die Steuereinheit der Heizvorrichtung 11, erfasst, wodurch ein Test des Bimetallschalters 12 unmittelbar durch die Heizvorrichtung 11, bzw. durch die Steuereinheit 18, erfolgen kann und damit keine separate Steuereinheit zum Testen des Bimetallschalters 12 benötigt wird. Entsprechend wird durch das vorliegende Verfahren der Aufwand für das Testen des Bimetallschalters 12 deutlich reduziert.

Im vorliegenden Fall wird durch das Betätigen des Schalters 16 ein elektrisches Signal unterbrochen. Im gezeigten Fall handelt es sich um einen Stromkreis mit einem Teststrom als elektrisches Signal, der durch das Betätigen des Schalters 16 unterbrochen wird. Dadurch wird eine besonders effiziente und schnelle Funktionserkennung des Bimetallschalters 12 durch die Steuereinheit 16 ermöglicht. Entsprechend ist der Schalter 16 in Fig. 2 geöffnet, während er in Fig. 1 geschlossen ist.

Darüber hinaus wird im vorliegenden Fall das elektrische Signal mittels der Heizvorrichtung 11, bzw. der Steuereinheit 18 der Heizvorrichtung 11, überwacht, wodurch keine manuelle Überwachung während des Verfahrens nicht zwingend notwendig ist. Somit wird der Automatisierungsgrad erhöht.

Durch das Betätigen des Schalters 16, bzw. durch das Unterbrechen des elektrischen Signals, wird ein Regelungsvorgang der Heizvorrichtung 11 eingeleitet. Dadurch kann neben der Funktionsfähigkeit des Bimetallschalters 12 selbst auch die Funktionsfähigkeit der Heizvorrichtung 11 in Verbindung mit dem Bimetallschalter 12 getestet werden.

Im vorliegenden Fall wird durch den Regelungsvorgang ein Element 28 der Heizvorrichtung 11 betätigt, wodurch die Funktionsfähigkeit des Bimetallschalters 12 gezielt in Verbindung mit einzelnen Elementen 28 der Heizvorrichtung 11 getestet werden kann. Im gezeigten Fall handelt es sich bei dem Element 28 um ein Gasventil 30 welches durch den Regelvorgang geschlossen wird. Somit wird durch den Regelvorgang die Gaszufuhr zu einem Gasbrenner 32 der Heizvorrichtung 11 unterbrochen.

Darüber hinaus wird ein Signal generiert, welches Aufschluss über die Funktionsfähigkeit des Bimetallschalters 12 gibt. Bei dem Signal handelt es sich im gezeigten Fall um ein optisches Signal welches auf eine Anzeige 32 der Heizvorrichtung 11 ausgegeben wird. Alternativ wäre es aber auch denkbar, dass ein akustisches Signal ausgegeben wird. Wird während dem Test des Bimetallschalters, innerhalb einer festgelegten Zeit, kein Signal ausgegeben, so kann daraus geschlossen werden, dass der Bimetallschalter fehlerhaft montiert und/oder defekt ist.

## Patentansprüche

1. Verfahren zum Testen eines Bimetallschalters (12) einer Vorrichtung (10), insbesondere einer Heizvorrichtung (11), wobei in und/oder an
die Vorrichtung (11) eine Induktionsspule (26) gebracht wird, mittels welcher ein Bimetall (14) des Bimetallschalters (12) induktiv erhitzt wird,
wobei durch das induktive Erhitzen des Bimetalls (14) des Bimetallschalters (12) eine Biegung des Bimetalls (12) ausgeführt wird, durch welche ein Schalter (16) betätigt wird,
wobei ein Signal generiert wird, welches Aufschluss über die Funktionsfähigkeit des Bimetallschalters (12) gibt,
**dadurch gekennzeichnet, dass**
durch das Betätigen des Schalters (16), insbesondere durch das Unterbrechen des elektrischen Signals, ein Regelungsvorgang der Vorrichtung (10) eingeleitet wird, und
dass durch den Regelungsvorgang ein Element (28), insbesondere ein Gasventil, der Vorrichtung (10) betätigt, vorzugsweise geschlossen, wird.

2. Verfahren nach Anspruch 1, **dadurch gekennzeichnet, dass** das Betätigen des Schalters (16) durch die Vorrichtung (10), vorzugsweise durch eine Steuereinheit (18) der Vorrichtung (11), erfasst wird.

3. Verfahren nach Anspruch 1 oder 2, **dadurch gekennzeichnet, dass** durch das Betätigen des Schalters (16) ein elektrisches Signal unterbrochen wird.

4. Verfahren nach Anspruch 3, **dadurch gekennzeichnet, dass** das elektrische Signal mittels der Vorrichtung (10), vorzugsweise der Steuereinheit (18) der Vorrichtung (11), überwacht wird.

5. Vorrichtung (22) zum Testen eines Bimetallschalters (12) einer Vorrichtung (10), welche dazu eingerichtet ist einen Bimetallschalter (12) mit einem Verfahren nach einem der Ansprüche 1 bis 5 zu testen.

6. Vorrichtung (22) zum Testen eines Bimetallschalters (12) einer Vorrichtung (10), nach Anspruch 5, **gekennzeichnet durch** eine Induktionsspule (26), welche dazu vorgesehen ist ein Bimetall (14) des Bimetallschalters (12) zu erhitzen.

7. Vorrichtung (10), insbesondere Heizvorrichtung (11), mit einem Bimetallschalter (12), welche dazu eingerichtet ist einen Bimetallschalter (12) mit einem Verfahren nach einem der Ansprüche 1 bis 5 zu testen.

8. Vorrichtung (10), insbesondere Heizvorrichtung (11), mit einem Bimetallschalter (12), nach Anspruch 6, **dadurch gekennzeichnet, dass** ein Positionierungselement (36) für eine Induktionsspule (26) zum Testen des Bimetallschalters (12) angeordnet ist.

## Claims

1. Method for testing a bimetallic switch (12) of a device (10), in particular a heating device (11), wherein an induction coil (26) is attached in and/or on the device (11), the induction coil being used to inductively heat a bimetal (14) of the bimetallic switch (12),
wherein the inductive heating of the bimetal (14) of the bimetallic switch (12) bends the bimetal (12), said bending actuating a switch (16),
wherein a signal which indicates the functionality of the bimetallic switch (12) is generated, **characterized in that**
the actuation of the switch (16), in particular the interruption of the electrical signal, initiates a control process of the device (10), and **in that** the control process actuates, in particular closes, an element (28),
in particular a gas valve, of the device (10).

2. Method according to Claim 1, **characterized in that** the actuation of the switch (16) is detected by the device (10), preferably by a control unit (18) of the device (11) .

3. Method according to Claim 1 or 2, **characterized in that** the actuation of the switch (16) interrupts an electrical signal.

4. Method according to Claim 3, **characterized in that** the electrical signal is monitored by means of the device (10), preferably the control unit (18) of the device (11) .

5. Device (22) for testing a bimetallic switch (12) of a device (10), which is designed to test a bimetallic switch (12) using a method according to one of Claims 1 to 5.

6. Device (22) for testing a bimetallic switch (12) of a device (10) according to Claim 5, **characterized by** an induction coil (26) which is provided to heat a bimetal (14) of the bimetallic switch (12).

7. Device (10), in particular heating device (11), having a bimetallic switch (12), which is designed to test a bimetallic switch (12) using a method according to one of Claims 1 to 5.

8. Device (10), in particular heating device (11), having a bimetallic switch (12), according to Claim 6, **characterized in that** a positioning element (36) for an induction coil (26) is arranged to test the bimetallic switch (12).

## Revendications

1. Procédé pour tester un commutateur à bilame (12) d'un dispositif (10), notamment d'un dispositif de chauffage (11), une bobine d'induction (26) étant amenée dans et/ou sur le dispositif (11), au moyen de laquelle un bilame (14) du commutateur à bilame (12) est chauffé par induction,
une flexion du bilame (12) étant effectuée par le chauffage inductif du bilame (14) du commutateur à bilame (12), par laquelle un commutateur (16) est actionné,
un signal étant généré, lequel fournit un renseignement à propos de la capacité de fonctionnement du commutateur à bilame (12), **caractérisé en ce**
**qu'**un processus de régulation du dispositif (10) est initié par l'actionnement du commutateur (16), notamment par l'interruption du signal électrique, et en ce que par le processus de régulation, un élément (28),
notamment une vanne à gaz, du dispositif (10) est actionné, de préférence fermé.

2. Procédé selon la revendication 1, **caractérisé en ce que** l'actionnement du commutateur (16) est détecté par le dispositif (10), de préférence par une unité de commande (18) du dispositif (11).

3. Procédé selon la revendication 1 ou 2, **caractérisé en ce qu'**un signal électrique est interrompu par l'actionnement du commutateur (16).

4. Procédé selon la revendication 3, **caractérisé en ce que** le signal électrique est surveillé au moyen du dispositif (10), de préférence de l'unité de commande (18) du dispositif (11).

5. Dispositif (22) pour tester un commutateur à bilame (12) d'un dispositif (10), lequel est conçu pour tester un commutateur à bilame (12) avec un procédé selon l'une des revendications 1 à 5.

6. Dispositif (22) pour tester un commutateur à bilame (12) d'un dispositif (10), selon la revendication 5, **caractérisé par** une bobine d'induction (26), laquelle est prévue pour chauffer un bilame (14) du commutateur à bilame (12).

7. Dispositif (10), notamment dispositif de chauffage (11), comprenant un commutateur à bilame (12), lequel est conçu pour tester un commutateur à bilame (12) avec un procédé selon l'une des revendications 1 à 5.

8. Dispositif (10), notamment dispositif de chauffage (11), comprenant un commutateur à bilame (12), selon la revendication 6, **caractérisé en ce qu'**un élément de positionnement (36) pour une bobine d'induction (26) est installé pour tester le commutateur à bilame (12).
